# EUROPEAN PATENT SPECIFICATION

(11) **EP 3 789 805 B1**
(45) Date of publication and mention of the grant of the patent: **09.08.2023**
(21) Application number: 19195378.5
(22) Date of filing: 04.09.2019
(51) Int. Cl.: G02B 6/42

(54) **BONDED STRUCTURE AND METHOD FOR MANUFACTURING A BONDED STRUCTURE**
VERBUNDSTRUKTUR UND VERFAHREN ZUR HERSTELLUNG EINER VERBUNDSTRUKTUR
STRUCTURE LIÉE ET PROCÉDÉ DE FABRICATION D'UNE STRUCTURE LIÉE

(43) Date of publication of application: 10.03.2021
(73) Proprietor: AMS AG, 8141 Premstätten (AT)
(72) Inventor: Kraft, Jochen, 8141 Premstätten (AT); Stering, Bernhard, 8141 Premstätten (AT); Steele, Colin, 8141 Premstätten (AT); Seurin, Jean Francois, 8141 Premstätten (AT)
(74) Representative: Epping - Hermann - Fischer

(56) References cited:
- EP-A1- 1 120 673
- US-A1- 2013 330 035
- US-A1- 2014 124 917
- US-A1- 2015 010 270

## Description

This disclosure relates to a flip-chip bonded structure and to a method for manufacturing a flip-chip bonded structure.

Flip-chip mounting is a common method for physically and electrically connecting an integrated circuit die to a substrate such as a circuit board. "Flipping" in this context refers to the fact that an active face of the die is mounted face down onto the substrate. Electrical bonding pads on both components are aligned with respect to each other and connected by means of electrically conductive connectors such as metallic solder balls. The flip-chip mounting method eliminates the use of bonding wires between the two components, leading to a more robust die-to-substrate bond with an increased reliability.

Also for optical applications in which a photonic integrated circuit, PIC, is mounted to a separate die, flip-chip mounting has become a common technique. Many of these applications employ an integrated light source, such as a vertical-cavity surface-emitting laser, VCSEL, on a first die that is flip-chip mounted to a second die that comprises further optical elements such as optical waveguide structures and a coupling element for receiving light from the light source and coupling it into the waveguide structure, for instance. Typically, these coupling elements are configured to operate at a certain coupling angle that is different from the perpendicular of the coupling element by a few degrees. As a VCSEL typically emits along the perpendicular of the surface of its die, a tilt between the PIC die and the die comprising the light source is required for an efficient operation. Conventional approaches realize this tilt by employing differently dimensioned connectors such as solder balls with different diameters. This, however, leads to a complicated fabricated process and potentially to a less reliable result due to imperfections when forming said connectors.

US 2015/0010270 A1 discloses an arrangement of an optoelectronic component and a substrate with an optical waveguide and an optical coupling location for coupling in and/or out an optical a radiation into and/or out of the optical waveguide. The optical coupling location is designed in a manner such that the radiation is coupled in and/or out with an angle of greater than 2° to the perpendicular to the substrate surface. The connection elements have different heights in order to achieve the desired tilt angle after the connection of the optoelectronic component to the substrate.

Similarly, US 2014/0124917 A1 relates to a method for alignment of a first substrate coupled to a second substrate that includes determining an inclination angle for the first substrate or the second substrate due to warpage. The method includes determining a joint height difference based on the inclination angle and configuring a size for one or more bond pads based on the joint height difference.

An object to be achieved is to provide an improved concept for a tilted flip-chip bonded structure and for a method for forming such a flip-chip bonded structure.

This object is achieved with the subject-matter of the independent claims. Embodiments and developments of the improved concept are defined in the dependent claims.

The improved concept is based on the idea of using a single type of connection elements regarding their material, shape and size and to realize a nominal tilt angle via variations of the surface sizes of the bonding pads on the two dies that are to be bonded. In particular, in a reflow process during the manufacturing, the connection elements distribute across the surface of the bonding pads such that a varying vertical extent of the connection elements is achieved, leading to the desired tilt angle of one die with respect to the other.

A bonded structure according to the improved concept comprises a substrate component having a plurality of first pads arranged on or within a surface of the substrate component, and an integrated circuit component having a plurality of second pads arranged on or within a surface of the integrated circuit component. The bonded structure further comprises a plurality of connection elements physically connecting the first pads to the second pads. The surface of the integrated circuit component is tilted obliquely to the surface of the substrate component at a tilt angle. The tilt angle results from nominal variations of surface sizes of the first and second pads.

The substrate component, for example, is a semiconductor substrate that may comprise an integrated circuit portion having a photonic integrated circuit, PIC, for instance. The PIC may comprise an optical waveguide structure and a coupling region for coupling in and/or out an optical radiation into and/or out of the optical waveguide. The coupling region may be a grating coupling element such as a Bragg grating coupler.

The surface of the substrate component may be a processed surface, which is parallel to a main plane of extension of the substrate component, and may be referred to as the top surface of the substrate component. The first pads are bonding pads that are arranged on or within said surface such that they are exposed to an environment of the substrate component for bonding to the integrated circuit component.

The integrated circuit component, for example, comprises active circuitry such as an application-specific integrated circuit. Moreover, the integrated circuit component may comprise an optoelectronic component such as a light source, in particular a surface emitter such as a VCSEL, and/or a photodetector.

Analogous to the substrate component, the surface of the integrated circuit component may be a processed surface, which is parallel to a main plane of extension of the integrated circuit component, and may likewise be referred to as the top surface of the integrated circuit component. The second pads are bonding pads that are arranged on or within said surface such that they are exposed to an environment of the integrated circuit component for bonding to the substrate component.

The connection elements are configured to establish a physical connection between the first pads and the second pads. In other words, the connection elements are bonding elements realizing the bonding between the substrate component and the integrated circuit component. For example, the connection elements are solder bumps.

Typically, the tilt angle in these devices between the integrated circuit component and the substrate component after establishing the bonding is larger than 2° and less than 10°. The tilt angle results from the equal diameter, and hence volume, of all connection elements in combination with nominal variations of surfaces of the first and second pads. Nominal in this context refers to intended design differences of the surfaces.

VCSELs, as all lasers, lose power if part of the emitted light is back-reflected into the laser. The bonded structure with the tilted integrated circuit component with respect to the substrate component therefore realizes the efficient prevention of back reflection into the VCSEL from the surface of the integrated circuit component.

In some embodiments, each of the plurality of connection elements is distributed across the entire surface of a respective one of the plurality of first pads and a respective one of the plurality of second pads.

In these embodiments, the distribution of each connection element across the surface of a respective first and second pad, i.e. those pads between which the connection element establishes a physical connection, is achieved by means of a reflow soldering process, for instance. During manufacturing, the material of the connection element is elevated to its eutectic temperature, typically around 200°C, such that the connection element becomes liquid and consequently spreads across the entire surface of the first and second pad before hardening when cooling down.

In some embodiments, a diameter of the plurality of connection elements varies by less than 5%, in particular by less than 2%.

As the diameter and/or volume of all connection elements employed is equal down to fabrication tolerances that may be up to 5%, merely the nominal variations in the pad surfaces therefore cause the desired tilt angle.

In some embodiments, a vertical extent, measured from the surface of the substrate component in a perpendicular direction, of a respective one of the plurality of connection elements depends on the surface sizes of the first pad and the second pad connected to each other by said connection element.

If the connection element is configured to distribute across the surface of a respective first and second pad, its vertical extent is then a function of the diameter and/or volume of the connection element and the surface sizes of said first and second pad. For example, nominally smaller first and second pads lead to a larger vertical extent of the respective connection element between said pads compared to nominally larger first and second pads for another connection element of the same diameter and/or volume. Nominal variations of the pad sizes for different connection elements therefore result in the intended tilt angle after bonding.

In some embodiments, the nominal variations of surface sizes of the first and second pads result from an increased or decreased nominal size of at least one of the first and second pads with respect to the remaining first and second pads.

In order to realize a desired tilt angle, it may be sufficient to merely vary the surface size of a single one of the first and second pads. For example, one of the first pads has a nominal first surface size while the remaining first pads and/or second pads have a nominal second surface size. The first surface size may be smaller or larger than the second surface size in these embodiments in order to realize a nominal tilt angle. Alternatively, one of the second pads may have the nominal first surface size while the remaining second pads and/or first pads have the nominal second surface size. Alternatively, more than one of the first and second pads may have a different surface compared to the remaining pads.

In some embodiments, connection elements are solder elements, such as solder balls or solder discs.

For bonding, solder elements such as preformed tin solder balls or discs can be conveniently arranged on the bonding pads in an automated mass production manner. For example, the solder elements are placed onto the first pads of the substrate component followed by a first reflow process in order to melt the solder elements and to fill the available surface size of the first pads. Subsequently, the integrated circuit component is arranged face down and aligned such that the second pads are aligned to and in contact with the solder elements. A second reflow process again melts the solder elements to now fill the available surface size of the first and second pads. This reflow method has the further advantage of performing a self-alignment of the substrate component and the integrated circuit component with respect to each other due to the minimization of the surface energy of the solder elements during the reflow process.

In some embodiments, a portion of the plurality of the connection elements also electrically connects the first pads to the second pads.

Often, bonding elements in addition to the physical connection are also configured to establish an electrical connection between the bonding pads. Choosing materials of both the bonding pads and the connection elements to be electrically conductive ensures a sufficient desired electrical connection between respective first and second pads after bonding. Suitable materials includes metals such as tin.

In some embodiments, the substrate component comprises an optical waveguide and a coupling region for coupling in and/or out an optical radiation into and/or out of the optical waveguide.

In some embodiments, the tilt angle corresponds to a coupling angle of the coupling region.

The tilt angle may be conventionally designed to correspond to a coupling angle of the coupling region. For example, the substrate body comprises a mirror, such as a Bragg mirror, or a grating coupler such as a Bragg grating, that is characterized by a certain coupling angle and the integrated circuit component comprises a VCSEL light source emitting light that is configured to be coupled into a waveguide structure by means of the coupling region. To this end, the tilt angle may be designed to correspond to the coupling angle in order to realize efficient coupling. Typically, the coupling angle of a grating coupler is in the order of 2-10°.

In some embodiments, the substrate component is an application-specific integrated circuit, a photonic integrated circuit or a printed circuit board.

In some embodiments, the first pads and the second pads have circular pad surfaces.

Circular pad surfaces due to their symmetry may enhance the uniform distribution of the connection elements across the entire surface of the first and second pads.

The object is further solved by a sensing device that comprises a bonded structure according to one of the embodiments described above, wherein the sensing device is configured as a gas sensor, a particle sensor, a biosensor and/or a pressure sensor.

The object is further solved by a method for manufacturing a bonded structure. The method comprises providing a substrate component having a plurality of first pads arranged in recesses formed on a surface of the substrate component, depositing a connection element on each of the plurality of first pads, and arranging, by method of flip-chip assembly, an integrated circuit component having a plurality of second pads arranged in recesses formed on a surface of the integrated circuit component such that each of the plurality of second pads is located above a connection element. The method further comprises connecting the integrated circuit component to the substrate component by means of a reflow process, wherein the surface of the integrated circuit component is tilted obliquely to the surface of the substrate component at a tilt angle. A tilt angle results from nominal variations of surface sizes of the first and second pads.

In some embodiments, the method comprises performing a first step of reflow for connecting the connection elements with the first pads, and performing a second step of reflow for connecting the connection elements with the second pads.

Further embodiments of the method become apparent to the skilled reader from the embodiments of the bonded structure described above.

The following description of figures of exemplary embodiments may further illustrate and explain aspects of the improved concept. Components and parts of the bonded structure with the same structure and the same effect, respectively, appear with equivalent reference symbols. Insofar as components and parts of the bonded structure correspond to one another in terms of their function in different figures, the description thereof is not repeated for each of the following figures.
- Figure 1: shows a cross-sectional schematic view of a substrate component and an integrated circuit component according to the improved concept before bonding;
- Figures 2 to 4: show cross sections of intermediate steps of an exemplary embodiment of a bonded structure according to the improved concept; and
- Figures 5 to 7: show exemplary embodiments of a finalized bonded structure according to the improved concept.

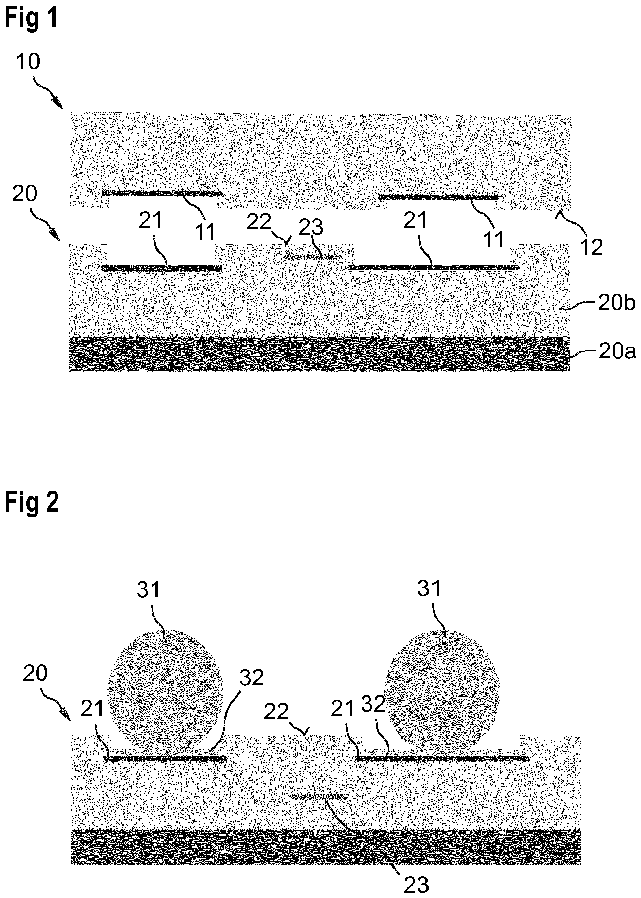

Figure 1 shows a cross-sectional schematic view of an exemplary embodiment of a substrate component 20 and an integrated circuit component 10 according to the improved concept before bonding.

The substrate component 20 for example comprises a substrate portion 20a, which may be a semiconductor substrate such as silicon, and an integrated circuit portion 20b. The latter may be a processed part of the substrate component comprising active circuitry of an application-specific integrated circuit and/or components of a photonic integrated circuit such as waveguide structures and a coupling element. The substrate component 20 in the integrated circuit portion 20b further comprises the first pads 21, which are bonding pads arranged on or within the surface 22 of the substrate component 20 that faces away from the substrate portion 20a.

In this embodiment the first pads 21 are arranged in recesses that are formed within the integrated circuit portion 20b. Before bonding, the first pads 21 are exposed to an environment of the substrate component 20.

In this specific embodiment, the integrated circuit portion 10b comprises a coupling region 23, e.g. a grating coupler, that is arranged in between the first pads 21. In general, different positions of the grating coupler 23 may be realized with respect to a vertical distance from the surface 22. Vertical in this context refers to the direction that is perpendicular to the surface 22. For example, the grating coupler 23 may be arranged closer to or further from the surface 22 compared to the first pads 21. In other words, the grating coupler 23 may be arranged in a level above the first pad level. This is the case, when wave guides and/or grating couplers are fabricated in a post processing flow, e.g. PE-CVD SiN deposition after passivation of the chip. Alternatively, the grating coupler 23 is positioned below the metal layer, i.e. below the first pad level. This is a typical situation for Si-based waveguides fabricated from SOI substrates.

The Figure 1 further shows an exemplary integrated circuit component 10. The integrated circuit component analogously to the substrate component 20 comprises second pads 11 that are likewise bonding pads arranged on or within a surface 12 of the integrated circuit component 10 that may be referred to as the processed or top surface. The integrated circuit component 10 may likewise comprise active circuitry of an application-specific integrated circuit and/or components of a photonic integrated circuit. In particular, the integrated circuit component 10 may comprise a surface emitting light source such as a VCSEL that is configured to emit light through the surface 12 in a direction towards the substrate component 20 in this arrangement. Typically, a VCSEL is configured to emit light in a perpendicular manner relative to the main plane of extension of the die it is comprised by, which in this case corresponds to a vertical direction with respect to the surface 12.

Regarding the first and second pads 11, 21, a nominal variation of the surface sizes is realized by designing and fabricating at least one of the bonding pads with a substantially different surface. In this exemplary embodiment, one of the first pads 21 is realized with a substantially larger surface compared to the remaining first and second pads 11, 21.

Figure 2 shows a cross section of an intermediate step of an exemplary embodiment of a bonded structure according to the improved concept. In this step, the connection elements 31 are placed onto the substrate component 20. The connection elements 31 are for example tin solder balls that are placed onto the bonding pads 21 by means of a ball drop stencil. The connection elements 31 are of a single type with respect to material, shape and size within tolerances of less than 5%, in particular less than 2%. This way, on a wafer scale a large number of connection elements 31 may be placed simultaneously via established mass production processes.

In order to maintain as low as possible tolerances, using pre-formed solder balls is preferred over solder paste screen print. Furthermore, in order to establish a sufficient physical and/or electrical contact after a reflow phase, flux 32 may be arranged on the first pads 21 prior to the placement of the connection elements 31. The flux may be applied either via spin-on or via a screen print process. The flux further aids in improving a self-aligning effect when the connection element 31 is in a liquid state during the reflow process as the flux removes potentially present oxide layers and it is promoting sufficient wetting between the connection element and the under bump metallization, UMB, which refers to a solderable layer on the first pads 21.

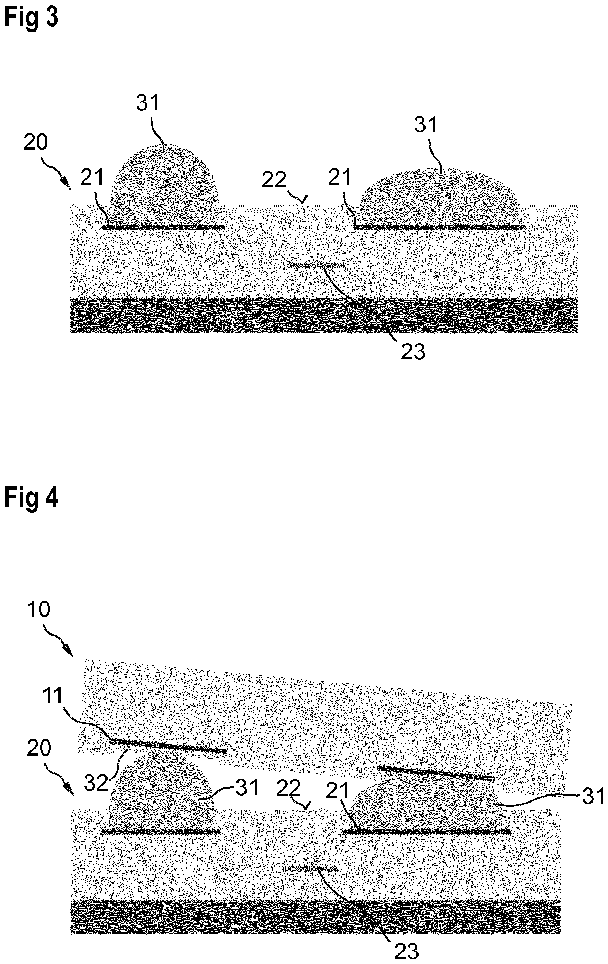

Figure 3 shows a cross section of a further intermediate step of an exemplary embodiment of a bonded structure according to the improved concept. Following the placement of the connection element described and illustrated in Figure 2, in this step a first reflow process as applied. The substrate component 20, or a wafer comprising a number of substrate components 20, and the connection elements 31 are heated up to a temperature of around 260°C. At this temperature, the flux 32 vaporizes while the connection elements 31 melt and fill the available pad size completely. In other words, the connection elements distribute across the entire surface of the first pads 21. After the reflow process, i.e. after cooling down such that the connection elements 31 resolidify, the shape of the connection elements 31 is merely a function of their diameter and the surface sizes of the first pads 21. As gravity is negligible in this scale - the connection elements are typically of a diameter less than 500 µm diameter - the surface tension of the material of the connection elements 31 causes a perfect ball shape.

The vertical extent of the connection elements 31 after the first reflow process is defined by the surface sizes of the first pads 21, i.e. the UBM surface, and by the diameter and/or volume of the connection elements 31. As it is clearly illustrated, the vertical extents of the connection elements 31 differ substantially due to the different surface sizes of the first pads 21.

Figure 4 shows a cross section of a further intermediate step of an exemplary embodiment of a bonded structure according to the improved concept. Following the first reflow process, the integrated circuit component 10 is in this step arranged in a flip-chip manner, i.e. face down with its surface 12 facing the surface 22 of the substrate component 20. Likewise, the second pads 11 are aligned with the connection elements 31. Analogous to the first pads 21 prior to the placement of the connection elements 31, flux 32 may be also applied onto the second pads 11 prior to the placement of the integrated circuit component 10 onto the connection elements 31 for the same reasons as stated above and to improve an adhesion of the integrated circuit component 10 prior to a second reflow process. The integrated circuit component 10 is placed via a mass production capable pick-and-place process, which typically exhibits an alignment accuracy of around 25pm. Likewise, a number of integrated circuit components 10 may be arranged on a wafer such that this step can be performed to place multiple integrated circuit components 10 over a corresponding number of substrate components 20.

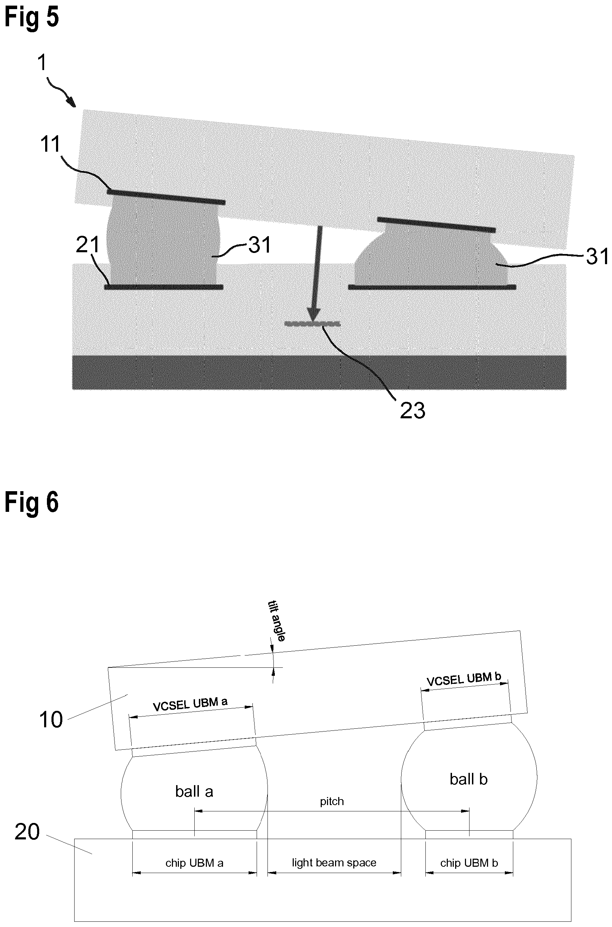

Figure 5 shows a cross section of a finalized exemplary embodiment of a bonded structure according to the improved concept. For finalizing the bonding, a second reflow process analogous to the first reflow process is applied causing the connection elements 31 to again melt and distribute also across the surfaces of the first second pads 11. After the reflow, i.e. after re-solidifying the connection elements 31, the bonded structure 1 with a tilt angle between the substrate component 20 and the integrated circuit component 10 is finalized.

During this second reflow step, the lateral position of the integrated circuit component 10, which may be a VCSEL die, is adjusted in a way that the surface energy of the connection elements 31 is minimized. Thus, the alignment of the first pads 21 to the second pads 11 is self-adjusted. As the position of the laser beam exit is aligned to the pads by means of lithography, a high degree of alignment accuracy of the laser beam to the grating element 23 is achieved.

Figure 6 illustrates the geometrical aspects that define the tilt angle α. Due to employing a single type of connection elements 31 and nominally varying the surface sizes of the first and second pads 11, 21, the tilt angle α results from the distribution of the connection elements 31 across the respective ones of the first and second pads 11, 21. In particular, the tilt angle α is a function of the diameter and/or volume of the connection elements 31, the surfaces of the first and second pads 11, 21 and the pitch between the pads that is likewise used as open space for the light beam.

For example, as illustrated in Figure 6, choosing circular pad surfaces for solder ball a to have a diameter of 75 µm and circular pad surfaces for solder ball b to have a diameter of 53 µm diameter in conjunction with a pitch of 166 µm and the solder balls being of a 80 µm diameter, which is a typical size, leads to a tilt angle of around 5° which corresponds to the coupling angle of common grating couplers. This tilt angle may be fine-tuned by further varying the pad surfaces, either individually or pairwise.

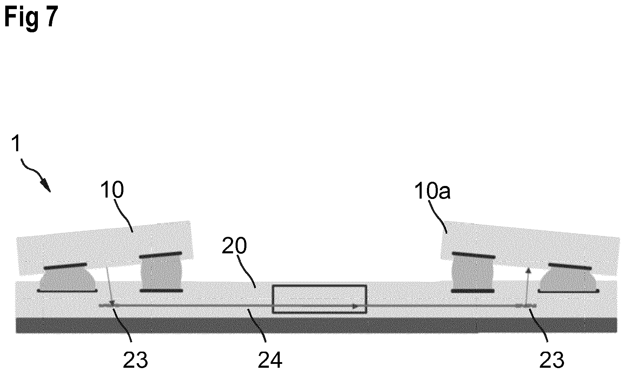

Figure 7 illustrates an embodiment of a bonded structure that comprises a further integrated circuit component 10a. While the first integrated circuit component 10 comprises a light source, e.g. a VCESL, the further integrated circuit component 10a may comprise a photodetector for analyzing light received from said light source. The substrate component in this embodiment comprises a further coupling region 23a and a waveguide structure 24 for guiding the light towards the detector.

The tilt angle of the further integrated circuit component 10a with respect to the substrate component 20 may correspond to that of the integrated circuit component 10, e.g. in case the two grating elements 23, 23a have an equal coupling angle, or it may be different which may be achieved via different nominal variations of the surface sizes of the respective first and second pads 11, 21.

The connection elements 31 in various embodiments establish both a physical and electrical connection. Regarding the embodiment of Figure 7, the light source and the photodetector may both be electrically connected to an ASIC that is either stacked to or is part of the substrate component 20. In the latter case, the photonic part may be realized via post processing on top of an ASIC.

The embodiments of the bonded structure 1 illustrated and described above may be conveniently employed in applications of optical sensing with wave guides. Applications include optical sensors based on ring resonators, Mach-Zehnder interferometers or Fabry-Perot interferometers. Si-based photonics is the technology making use of the advanced processing techniques established in semiconductor electronic devices. With respect to the light source Silicon, however, is an indirect semiconductor and therefore not suitable for light generation. Light sources like VCSELs and photodetectors operated at wavelengths larger than 1050nm may be manufactured based on other types of semiconductors that have a direct band-gap such as III/V substrates that are in a final step bonded to a PIC.

### Reference symbols

- 1: bonded structure
- 10: integrated circuit component
- 10a: further integrated circuit component
- 11: second pads
- 12: surface
- 20: substrate component
- 20a: substrate portion
- 20b: integrated circuit portion
- 21: first pads
- 22: surface
- 23, 23a: coupling region
- 24: waveguide structure
- α: tilt angle

## Claims

1. A bonded structure (1) comprising
- a substrate component (20) having a plurality of first pads (21) arranged on or within a surface (22) of the substrate component (20);
- an integrated circuit component (10) having a plurality of second pads (11) arranged on or within a surface (12) of the integrated circuit component (10); and
- a plurality of connection elements (31) physically connecting the first pads (21) to the second pads (11), wherein
-
- the surface (12) of the integrated circuit component (10) is tilted obliquely to the surface (22) of the substrate component (20) at a tilt angle (α);
- the tilt angle (α) results from nominal variations of surface sizes of the first and second pads (21, 11)
**characterised in that** the first pads (21) and/or the second pads (11) are arranged in recesses formed on the respective surface (22,12).

2. The bonded structure (1) according to claim 1, wherein each of the plurality of connection elements (31) is distributed across the entire surface of a respective one of the plurality of first pads (21) and a respective one of the plurality of second pads (11).

3. The bonded structure (1) according to claim 1 or 2, wherein a diameter of the plurality of connection elements (31) varies by less than 5%.

4. The bonded structure (1) according to one of claims 1 to 3, wherein a vertical extent, measured from the surface (22) of the substrate component (20) in a perpendicular direction, of a respective one of the plurality of connection elements (31) depends on the surface sizes of the first pad (21) and the second pad (11) connected to each other by said connection element (31).

5. The bonded structure (1) according to one of claims 1 to 4, wherein the nominal variations of surface sizes of the first and second pads (21, 11) result from an increased or decreased nominal size of at least one of the first and second pads (21, 11) with respect to the remaining first and second pads (21, 11).

6. The bonded structure (1) according to one of claims 1 to 5, wherein the connection elements (31) are solder elements, such as solder balls or solder disks.

7. The bonded structure (1) according to one of claims 1 to 6, wherein a portion of the plurality of the connection elements (31) also electrically connects the first pads (21) to the second pads (11).

8. The bonded structure (1) according to one of claims 1 to 7, wherein the substrate component (20) comprises an optical waveguide (24) and a coupling region (23) for coupling in and/or out an optical radiation into and/or out of the optical waveguide (24).

9. The bonded structure (1) according to claim 8, wherein the tilt angle (α) corresponds to a coupling angle of the coupling region (23).

10. The bonded structure (1) according to claim 8 or 9, wherein the coupling region (23) comprises a grating coupler and/or a mirror.

11. The bonded structure (1) according to one of claims 1 to 10, wherein the integrated circuit component (10) comprises an optoelectronic component such as a light source, in particular a surface emitter such as a VCSEL, and/or a photodetector.

12. The bonded structure (1) according to one of claims 1 to 11, wherein the first pads (21) and the second pads (11) have circular pad surfaces.

13. A sensing device comprising a bonded structure (1) according to one of claims 1 to 12, wherein the sensing device is configured as a gas sensor, a particle sensor, a biosensor and/or a pressure sensor.

14. Method for manufacturing a bonded structure (1), the method comprising
- providing a substrate component (20) having a plurality of first pads (21) arranged in recesses formed on a surface (22) of the substrate component (20);
- depositing a connection element (31) on each of the plurality of first pads (21);
- arranging, by method of flip-chip assembly, an integrated circuit component (10) having a plurality of second pads (11) arranged in recesses formed on a surface (12) of the integrated circuit component (10) such that each of the plurality of second pads (11) is located above a connection element (31); and
- connecting the integrated circuit component (10) to the substrate component (20) by means of a reflow; wherein- the surface (12) of the integrated circuit component (10) is tilted obliquely to the surface (22) of the substrate component (20) at a tilt angle (α); and
- the tilt angle (α) results from nominal variations of surface sizes of the first and second pads (21, 11).

15. The method according to claim 14, wherein the method comprises
- performing a first step of reflow for connecting the connection elements (31) with the first pads (21); and
- performing a second step of reflow for connecting the connection elements (31) with the second pads (11).

## Patentansprüche

1. Eine Verbundstruktur (1), aufweisend
- ein Substratbauteil (20) mit einer Vielzahl von ersten Pads (21), die auf oder innerhalb einer Oberfläche (22) des Substratbauteils (20) angeordnet sind;
- ein integriertes Schaltkreisbauteil (10) mit einer Vielzahl von zweiten Pads (11), die auf oder innerhalb einer Oberfläche (12) des integrierten Schaltkreisbauteils (10) angeordnet sind; und
- eine Vielzahl von Verbindungselementen (31), die die ersten Pads (21) mit den zweiten Pads (11) physisch verbinden, wobei
- die Oberfläche (12) des integrierten Schaltkreisbauteils (10) schräg zur Oberfläche (22) des Substratbauteils (20) mit einem Verkippungswinkel (α) verkippt ist;
- der Verkippungswinkel (α) ergibt sich aus den nominalen Abweichungen von Oberflächengrößen der ersten und zweiten Pads (21, 11)
**dadurch gekennzeichnet, dass** die ersten Pads (21) und/oder die zweiten Pads (11) in Vertiefungen angeordnet sind, die an der jeweiligen Oberfläche (22, 12) ausgebildet sind.

2. Die Verbundstruktur (1) nach Anspruch 1, wobei jedes der Vielzahl von Verbindungselementen (31) über die gesamte Oberfläche eines jeweiligen der Vielzahl von ersten Pads (21) und eines jeweiligen der Vielzahl von zweiten Pads (11) verteilt ist.

3. Die Verbundstruktur (1) nach Anspruch 1 oder 2, wobei ein Durchmesser der Vielzahl von Verbindungselementen (31) um weniger als 5% variiert.

4. Die Verbundstruktur (1) nach einem der Ansprüche 1 bis 3, wobei eine von der Oberfläche (22) des Substratbauteils (20) in senkrechter Richtung gemessene vertikale Ausdehnung eines jeweiligen der Vielzahl von Verbindungselementen (31) von den Oberflächengrößen des ersten Pads (21) und des zweiten Pads (11) abhängt, die durch das Verbindungselement (31) miteinander verbunden sind.

5. Die Verbundstruktur (1) nach einem der Ansprüche 1 bis 4, wobei die nominalen Variationen der Oberflächengrößen der ersten und zweiten Pads (21, 11) aus einer vergrößerten oder verkleinerten nominalen Größe von mindestens einem der ersten und zweiten Pads (21, 11) in Bezug auf die übrigen ersten und zweiten Pads (21, 11) resultieren.

6. Die Verbundstruktur (1) nach einem der Ansprüche 1 bis 5, wobei die Verbindungselemente (31) Lotelemente wie Lotkugeln oder Lotscheiben sind.

7. Die Verbundstruktur (1) nach einem der Ansprüche 1 bis 6, wobei ein Teil der Vielzahl von Verbindungselementen (31) die ersten Pads (21) mit den zweiten Pads (11) auch elektrisch verbindet.

8. Die Verbundstruktur (1) nach einem der Ansprüche 1 bis 7, wobei das Substratbauteil (20) einen optischen Wellenleiter (24) und einen Kopplungsbereich (23) zum Ein- und/oder Auskoppeln einer optischen Strahlung in den und/oder aus dem optischen Wellenleiter (24) aufweist.

9. Die Verbundstruktur (1) nach Anspruch 8, wobei der Verkippungswinkel (α) einem Kopplungswinkel des Kopplungsbereichs (23) entspricht.

10. Die Verbundstruktur (1) nach Anspruch 8 oder 9, wobei der Kopplungsbereich (23) einen Gitterkoppler und/oder einen Spiegel aufweist.

11. Die Verbundstruktur (1) nach einem der Ansprüche 1 bis 10, wobei das integrierte Schaltkreisbauteil (10) ein optoelektronisches Bauteil wie eine Lichtquelle, insbesondere einen Oberflächenemitter wie eine VCSEL, und/oder einen Photodetektor aufweist.

12. Die Verbundstruktur (1) nach einem der Ansprüche 1 bis 11, wobei die ersten Pads (21) und die zweiten Pads (11) kreisförmige Padflächen aufweisen.

13. Eine Sensorgerät mit einer Verbundstruktur (1) nach einem der Ansprüche 1 bis 12, wobei das Sensorgerät als Gassensor, Partikelsensor, Biosensor und/oder als Drucksensor eingerichtet ist.

14. Verfahren zur Herstellung einer Verbundstruktur (1), aufweisend
- Bereitstellen eines Substratbauteils (20) mit einer Vielzahl von ersten Pads (21), die in Vertiefungen auf einer Oberfläche (22) des Substratbauteils (20) ausgebildet sind;
- Aufbringen eines Verbindungselements (31) auf jedem der Vielzahl erster Pads (21);
- Anordnen eines integrierten Schaltkreisbauteils (10) mit einer Vielzahl von zweiten Pads (11), die in Vertiefungen auf einer Oberfläche (12) des integrierten Schaltkreisbauteils (10) ausgebildet sind, durch ein Verfahren der Flip-Chip-Montage, so dass jedes der Vielzahl von zweiten Pads (11) über einem Verbindungselement (31) angeordnet ist; und
- Verbinden des integrierten Schaltkreisbauteils (10) mit dem Substratbauteil (20) durch Aufschmelzen; wobei- die Oberfläche (12) des integrierten Schaltkreisbauteils (10) schräg zur Oberfläche (22) des Substratbauteils (20) mit einem Verkippungswinkel (α) verkippt ist; und
- sich der Verkippungswinkel (α) aus den nominellen Abweichungen von Oberflächengrößen der ersten und zweiten Pads (21, 11) ergibt.

15. Verfahren nach Anspruch 14, wobei das Verfahren aufweist
- Durchführen eines ersten Aufschmelz-Schrittes zum Verbinden der Verbindungselemente (31) mit den ersten Pads (21) ; und
- Durchführen eines zweiten Aufschmelz-Schrittes zum Verbinden der Verbindungselemente (31) mit den zweiten Pads (11).

## Revendications

1. Une structure collée (1) comprenant
- un composant de substrat (20) comportant une pluralité de premières pastilles (21) disposées sur ou à l'intérieur d'une surface (22) du composant de substrat (20);
- un composant de circuit intégré (10) comportant une pluralité de deuxièmes pastilles (11) disposés sur ou à l'intérieur d'une surface (12) du composant de circuit intégré (10) ; et
- une pluralité d'éléments de connexion (31) reliant physiquement les premières pastilles (21) aux deuxièmes pastilles (11), dans laquelle
- la surface (12) du composant à circuit intégré (10) est inclinée obliquement par rapport à la surface (22) du composant de substrat (20) à un angle d'inclinaison (α);
- l'angle d'inclinaison (α) résulte des variations nominales des tailles de surface des premier et deuxième pastilles (21, 11)
**caractérisé par le fait que** les premières pastilles (21) et/ou les deuxièmes pastilles (11) sont disposées dans des évidements formés sur la surface respective (22, 12).

2. La structure collée (1) selon la revendication 1, dans laquelle chacun des éléments de connexion (31) est réparti sur toute la surface de l'un des premières pastilles (21) et de l'un des deuxièmes pastilles (11).

3. La structure collée (1) selon la revendication 1 ou 2, dans laquelle un diamètre de la pluralité d'éléments de connexion (31) varie de moins de 5%.

4. La structure collée (1) selon l'une des revendications 1 à 3, dans laquelle une étendue verticale, mesurée à partir de la surface (22) du composant de substrat (20) dans une direction perpendiculaire, d'un élément de connexion respectif de la pluralité d'éléments de connexion (31) dépend des tailles de surface des premières pastilles (21) et des deuxièmes pastilles (11) reliés l'un à l'autre par ledit élément de connexion (31).

5. La structure collée (1) selon l'une des revendications 1 à 4, dans laquelle les variations nominales des tailles de surface des premières et deuxième pastilles (21, 11) résultent d'une taille nominale accrue ou réduite d'au moins un des premier et deuxième pastilles (21, 11) par rapport aux premières et deuxièmes pastilles (21, 11) restants.

6. La structure collée (1) selon l'une des revendications 1 à 5, dans laquelle les éléments de connexion (31) sont des éléments de soudure, tels que des billes ou des disques de soudure.

7. La structure collée (1) selon l'une des revendications 1 à 6, dans laquelle une partie de la pluralité des éléments de connexion (31) connecte également électriquement les premières pastilles (21) aux deuxièmes pastilles (11).

8. La structure collée (1) selon l'une des revendications 1 à 7, dans laquelle le composant de substrat (20) comprend un guide d'ondes optiques (24) et une région de couplage (23) pour coupler un rayonnement optique entrant et/ou sortant du guide d'ondes optiques (24).

9. La structure collée (1) selon la revendication 8, dans laquelle l'angle d'inclinaison (α) correspond à un angle de couplage de la région de couplage (23).

10. La structure collée (1) selon la revendication 8 ou 9, dans laquelle la région de couplage (23) comprend un coupleur à réseau et/ou un miroir.

11. La structure collée (1) selon l'une des revendications 1 à 10, dans laquelle le composant de circuit intégré (10) comprend un composant optoélectronique tel qu'une source de lumière, en particulier un émetteur de surface tel qu'un VCSEL, et/ou un photodétecteur.

12. La structure collée (1) selon l'une des revendications 1 à 11, dans laquelle les premières pastilles (21) et les deuxièmes pastilles (11) ont des surfaces de pastilles circulaires.

13. Dispositif de détection comprenant une structure collée (1) selon l'une des revendications 1 à 12, dans lequel le dispositif de détection est configuré comme un capteur de gaz, un capteur de particules, un biocapteur et/ou un capteur de pression.

14. Procédé de fabrication d'une structure collée (1), comprenant
- fournir un composant de substrat (20) ayant une pluralité de premières pastilles (21) disposés dans des évidements formés sur une surface (22) du composant de substrat (20);
- déposer un élément de connexion (31) sur chacun des premières pastilles (21);
- disposer, par une méthode d'assemblage de puces flip-chip, un composant de circuit intégré (10) comportant une pluralité de deuxièmes pastilles (11) disposés dans des évidements formés sur une surface (12) du composant de circuit intégré (10) de telle sorte que chacun des deuxièmes pastilles (11) soit situé au-dessus d'un élément de connexion (31); et
- connecter le composant de circuit intégré (10) au composant de substrat (20) au moyen d'une refusion; dans lequel- la surface (12) du composant de circuit intégré (10) est inclinée obliquement par rapport à la surface (22) du composant de substrat (20) à un angle d'inclinaison (α); et
- l'angle d'inclinaison (α) résulte des variations nominales de la taille des surfaces des premières et deuxièmes pastilles (21, 11).

15. La procédé selon la revendication 14, dans lequel le procédé comprend
- l'exécution d'une première étape de refusion pour connecter les éléments de connexion (31) avec les premières pastilles (21); et
- l'exécution d'une deuxième étape de refusion pour connecter les éléments de connexion (31) avec les deuxièmes pastilles (11) .
